# EUROPEAN PATENT APPLICATION

(11) **EP 4 692 575 A1**
(43) Date of publication of application: **11.02.2026**
(21) Application number: 24784318.8
(22) Date of filing: 03.04.2024
(51) Int. Cl.: F16C 11/04

(54) **HINGE STRUCTURE AND ELECTRONIC DEVICE**

(30) Priority: 03.04.2023 CN 202310345321
(71) Applicant: Vivo Mobile Communication Co., Ltd., Dongguan, Guangdong 523863 (CN)
(72) Inventor: CHENG, Dongcun, Dongguan, Guangdong 523863 (CN); ZHOU, Shuaiyu, Dongguan, Guangdong 523863 (CN); WANG, Teng, Dongguan, Guangdong 523863 (CN); LIU, Jianhua, Dongguan, Guangdong 523863 (CN)
(74) Representative: Conti, Marco
(86) International application number: PCT/CN2024/085707
(87) International publication number: WO 2024/208236

(57) **Abstract**

A hinge structure and an electronic device pertain to the technical field of electronic products. The hinge structure includes a base (301), a swing arm assembly (302), a rotating shaft (303), a friction plate (304), and a compression spring (305). The rotating shaft (303) is disposed on the base (301), both the swing arm assembly (302) and the friction plate (304) are disposed on the rotating shaft (303), and the swing arm assembly (302) is rotatably connected to the rotating shaft (303). The swing arm assembly (302) includes at least two damping plates (3021), the at least two damping plates (3021) are sleeved on the rotating shaft (303), the at least two damping plates (3021) are rotatably connected to the rotating shaft (303), the friction plate (304) is disposed between the at least two damping plates (3021), the at least two damping plates (3021) are in contact with the friction plate (304), the compression spring (305) is sleeved on the rotating shaft, and the compression spring (305) abuts against the swing arm assembly (302).

## Description

### CROSS-REFERENCE TO RELATED APPLICATIONS

This application claims priority to Chinese Patent Application No. 202310345321.4, filed on April 3, 2023, which is incorporated herein by reference in its entirety.

### TECHNICAL FIELD

This application pertains to the technical field of electronic products, and specifically, relates to a hinge structure and an electronic device.

### BACKGROUND

With development of flexible screen technologies, flexible screens have been widely used in design solutions such as rolling, sliding, and folding. In particular, when a flexible screen is used in an electronic device such as a foldable phone, the foldable phone needs to be thinner and lighter, with a narrower black border, to improve use experience of a user.

Because the foldable phone needs to hover in an unfolding or folding process, a damping assembly needs to be added to a hinge structure of the foldable phone. However, a damping assembly in a related technology mainly includes concave-convex wheels and springs, and the design of concave-convex wheels significantly increases an overall volume of the hinge structure.

It can be learned that the hinge structure of the foldable phone in the related technology has a problem of large space occupation.

### SUMMARY

This application aims to provide a hinge structure and an electronic device, to solve a problem of large space occupation in a hinge structure of a foldable phone in a related technology.

To solve the foregoing technical problem, this application is implemented as follows.

According to a first aspect, an embodiment of this application provides a hinge structure, including a base, a swing arm assembly, a rotating shaft, a friction plate, and a compression spring. The rotating shaft is disposed on the base, both the swing arm assembly and the friction plate are disposed on the rotating shaft, and the swing arm assembly is rotatably connected to the rotating shaft.

The swing arm assembly includes at least two damping plates, the at least two damping plates are sleeved on the rotating shaft, the at least two damping plates are rotatably connected to the rotating shaft, the friction plate is disposed between the at least two damping plates, the at least two damping plates are in contact with the friction plate, the compression spring is sleeved on the rotating shaft, and the compression spring abuts against the swing arm assembly.

According to a second aspect, an embodiment of this application provides an electronic device, including a first foldable part, a second foldable part, and the hinge structure according to the first aspect. The first foldable part is rotatably connected to the second foldable part through the hinge structure.

In embodiments of this application, elastic restoring force of the compression spring acts on surface contact between the at least two damping plates and the friction plate, so that rotational friction force between the at least two damping plates and the friction plate can be increased, to improve damping effect in rotation of the hinge structure. In addition, because the damping plates, the friction plate, and the compression spring are all sleeved on the rotating shaft, an overall volume of the hinge structure can be effectively reduced in comparison with achieving damping effect of a hinge structure by disposing a concave-convex wheel spring assembly.

Additional aspects and advantages of this application are partially provided in the following descriptions, and will partially become apparent from the following descriptions, or may be learned from practice of this application.

### BRIEF DESCRIPTION OF DRAWINGS

The foregoing and/or additional aspects and advantages of this application will become apparent and readily understood from the descriptions of embodiments with reference to the following accompanying drawings.
FIG. 1 is a schematic diagram of an electronic device that is closed according to an embodiment of this application;
FIG. 2 is a schematic diagram of the electronic device shown in FIG. 1 that is flattened;
FIG. 3 is a schematic diagram of a hinge structure in the electronic device shown in FIG. 1;
FIG. 4 is a schematic diagram of the hinge structure shown in FIG. 3 that is flattened;
FIG. 5 is a schematic diagram of the hinge structure shown in FIG. 3 that is closed;
FIG. 6 is an exploded view of the hinge structure shown in FIG. 3;
FIG. 7 is a diagram of a structure of a synchronization bracket shown in FIG. 6;
FIG. 8 is a diagram of a structure of a sliding groove swing arm shown in FIG. 6; and
FIG. 9 is a diagram of a structure of a floating plate shown in FIG. 3.

### DESCRIPTION OF EMBODIMENTS

The following describes in detail embodiments of this application. Examples of embodiments are shown in accompanying drawings. Reference numerals which are the same or similar throughout the accompanying drawings represent identical or similar elements or elements having identical or similar functions. Embodiments described below with reference to the accompanying drawings are merely examples, and are intended to explain this application without being construed as limiting this application. All other embodiments obtained by a person of ordinary skill in the art based on embodiments of this application without creative efforts shall fall within the protection scope of this application.

In the specification and claims of this application, features of the terms "first" and "second" may explicitly or implicitly include one or more such features. In the descriptions of this application, unless otherwise specified, "a plurality of" means two or more. In addition, in the specification and claims, "and/or" indicates at least one of connected objects, and the character "/" generally indicates an "or" relationship between associated objects.

In the descriptions of this application, it should be noted that, unless otherwise specified and defined explicitly, the terms "install", "join", and "connect" should be understood in a broad sense. For example, the terms may indicate a fixed connection, a detachable connection, or an integral connection; may indicate a mechanical connection or an electrical connection; or may indicate a direct connection, an indirect connection through an intermediate medium, or internal communication between two elements. For a person of ordinary skill in the art, specific meanings of the foregoing terms in this application may be understood based on a specific situation.

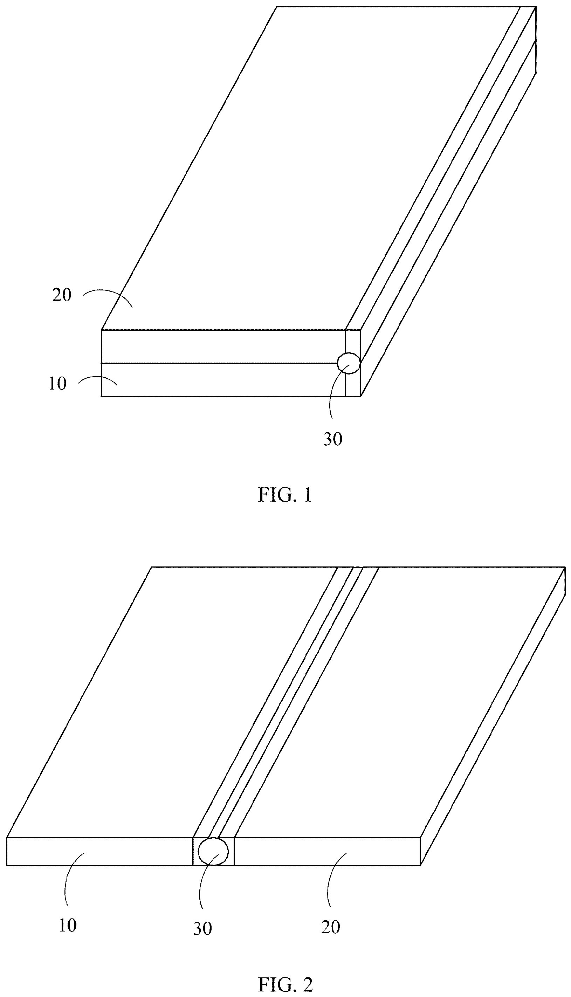

Refer to FIG. 1 and FIG. 2. FIG. 1 is a schematic diagram of an electronic device that is closed according to an embodiment of this application. FIG. 2 is a schematic diagram of the electronic device shown in FIG. 1 that is flattened. As shown in FIG. 1 and FIG. 2, the electronic device provided in this embodiment of this application includes a first foldable part 10, a second foldable part 20, and a hinge structure 30. The first foldable part 10 may be connected to the second foldable part 20 through the hinge structure 30. In addition, under an action of the hinge structure 30, the first foldable part 10 and the second foldable part 20 may rotate relative to each other, so that the electronic device can switch between a closed state shown in FIG. 1 and a flattened state shown in FIG. 2.

The closed state may be understood as that an unfolding angle between the first foldable part 10 and the second foldable part 20 is 0°, and the flattened state may be understood as that the unfolding angle between the first foldable part 10 and the second foldable part 20 is 180°.

In this embodiment of this application, an unfolding angle of the electronic device may range from 0° to 180°, to meet application requirements of the electronic device at different unfolding angles.

In some implementations, the unfolding angle of the electronic device may even range from 0° to 360°.

In addition, it may be understood that the electronic device may alternatively include three or more foldable parts. In a case that there are three or more foldable parts, a person skilled in the art may make corresponding expansions based on the technical idea of this application. Details are not described herein.

In addition, the electronic device in this embodiment of this application may be a foldable electronic device such as a foldable phone or a notebook computer.

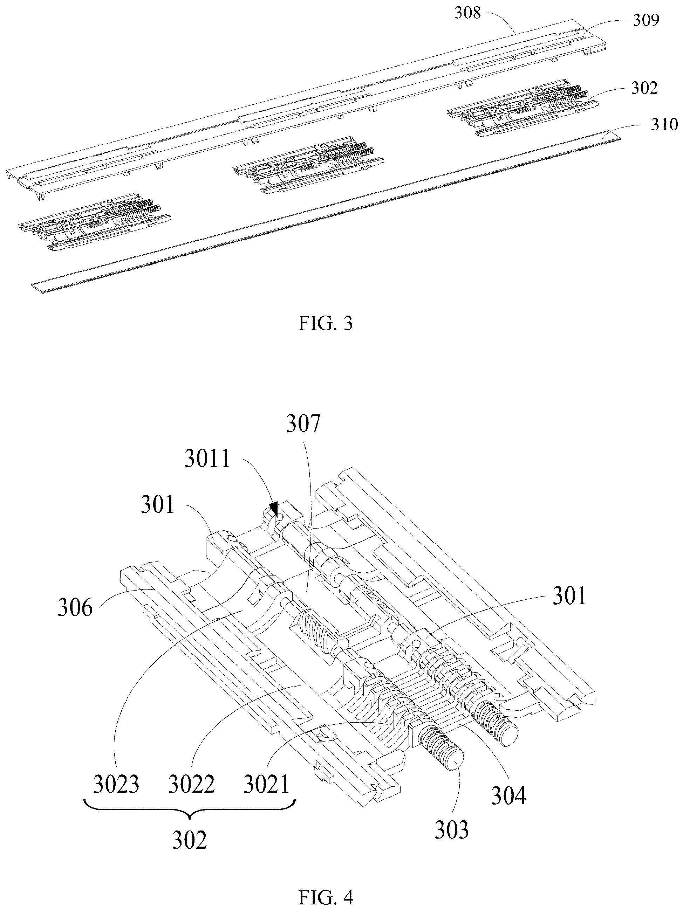

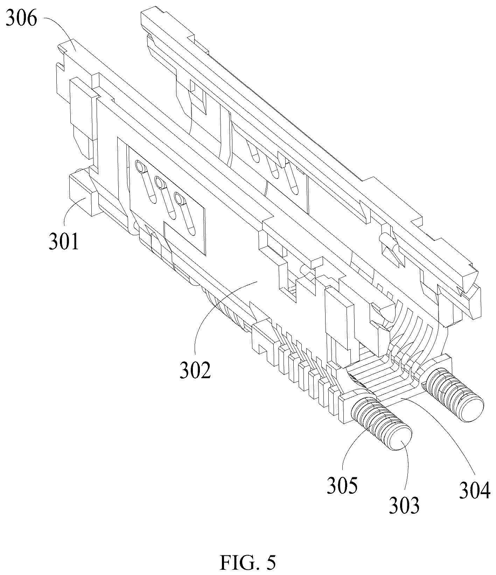

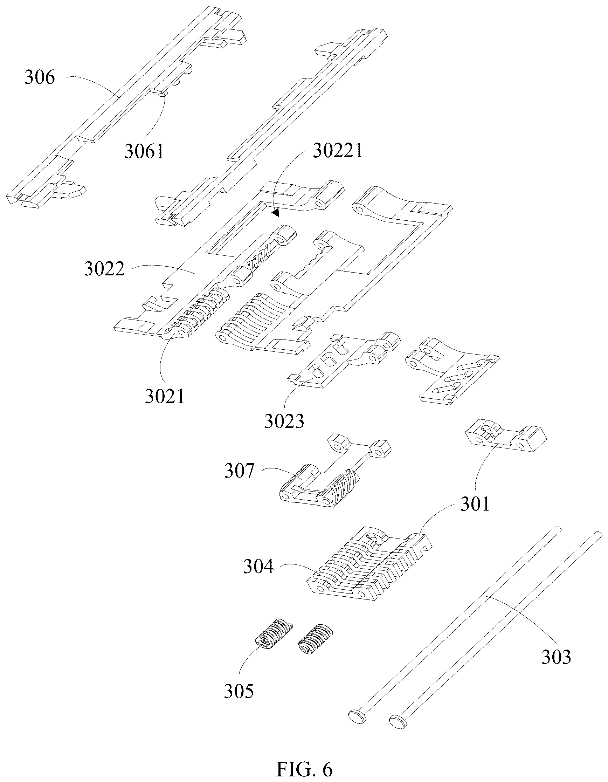

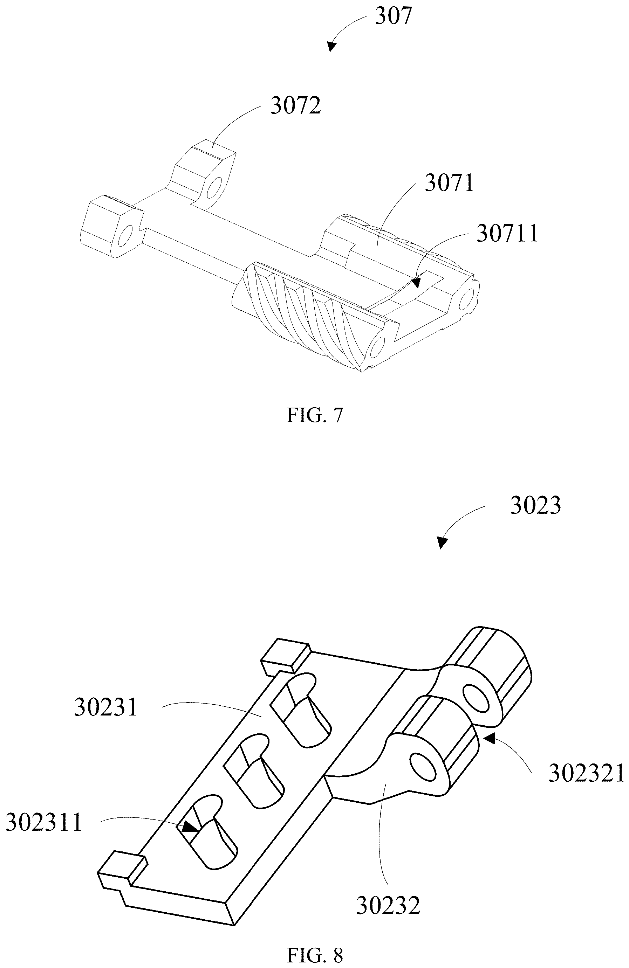

Refer to FIG. 3 to FIG. 8. FIG. 3 is a schematic diagram of a hinge structure in the electronic device shown in FIG. 1. FIG. 4 is a schematic diagram of the hinge structure shown in FIG. 3 that is flattened. FIG. 5 is a schematic diagram of the hinge structure shown in FIG. 3 that is closed. FIG. 6 is an exploded view of the hinge structure shown in FIG. 3. FIG. 7 is a diagram of a structure of a synchronization bracket shown in FIG. 6. FIG. 8 is a diagram of a structure of a sliding groove swing arm shown in FIG. 6. As shown in FIG. 3 to FIG. 8, the hinge structure 30 includes a base 301, a swing arm assembly 302, a rotating shaft 303, a friction plate 304, and a compression spring 305. The rotating shaft 303 is disposed on the base 301, both the swing arm assembly 302 and the friction plate 304 are disposed on the rotating shaft 303, and the swing arm assembly 302 is rotatably connected to the rotating shaft 303.

The swing arm assembly 302 includes at least two damping plates 3021, the at least two damping plates 3021 are sleeved on the rotating shaft 303, the at least two damping plates 3021 are rotatably connected to the rotating shaft 303, the friction plate 304 is disposed between the at least two damping plates 3021, the at least two damping plates 3021 are in contact with the friction plate 304, the compression spring 305 is sleeved on the rotating shaft 303, and the compression spring 305 abuts against the swing arm assembly 302.

The compression spring 305 abutting against the swing arm assembly 302 may be understood as follows: The compression spring 305 abuts against an end of the swing arm assembly 302 at which the at least two damping plates 3021 are disposed, elastic restoring force of the compression spring 305 may exert elastic force on the swing arm assembly 302, and the elastic force may act on the at least two damping plates 3021 of the swing arm assembly 302. In addition, because the friction plate 304 is disposed between the at least two damping plates 3021, the elastic restoring force of the compression spring 305 may act on the friction plate 304 and the damping plates 3021, and increase rotational friction force between the friction plate 304 and the damping plates 3021, so that there is a sense of damping in rotation of the hinge structure 30.

It may be understood that the contact between the at least two damping plates 3021 and the friction plate 304 may be surface contact. Setting the contact between the damping plates 3021 and the friction plate 304 to surface contact can further increase the rotational friction force between the damping plates 3021 and the friction plate 304, and enhance the sense of damping in rotation of the hinge structure 30.

Further, when the hinge structure 30 is used in the electronic device shown in FIG. 1, with the use of the sense of damping in rotation of the hinge structure 30, there can also be a sense of damping in an operation of opening/closing the electronic device, and experience pleasure is improved when a user performs an opening/closing operation.

In this implementation, the elastic restoring force of the compression spring 305 acts on the surface contact between the at least two damping plates 3021 and the friction plate 304, so that the rotational friction force between the at least two damping plates 3021 and the friction plate 304 can be increased, to improve damping effect in rotation of the hinge structure 30. In addition, because the damping plates 3021, the friction plate 304, and the compression spring 305 are all sleeved on the rotating shaft 303, an overall volume of the hinge structure 30 can be effectively reduced in comparison with achieving damping effect of a hinge structure by disposing a concave-convex wheel spring assembly.

Still refer to FIG. 4 to FIG. 8. The hinge structure 30 further includes a fastening bracket 306 and a synchronization bracket 307, the synchronization bracket 307 is disposed on the rotating shaft 303, the swing arm assembly 302 includes a synchronization swing arm 3022 and a sliding groove swing arm 3023, the at least two damping plates 3021 are disposed on the synchronization swing arm 3022, and the fastening bracket 306 is connected to the sliding groove swing arm 3023.

The synchronization swing arm 3022 is connected to the synchronization bracket 307.

In a case that the fastening bracket 306 rotates relative to the base 301, the fastening bracket 306 drives the synchronization swing arm 3022 to rotate, and the synchronization swing arm 3022 cooperates with the synchronization bracket 307 to drive the synchronization bracket 307 and the sliding groove swing arm 3023 to move along the rotating shaft 303.

The synchronization swing arm 3022 and the synchronization bracket 307 may be connected by a thread fit.

In this implementation, the synchronization swing arm 3022 is cooperatively connected to the synchronization bracket 307, so that rotation of the synchronization swing arm 3022 can drive the synchronization bracket 307 and the sliding groove swing arm 3023 to move along the rotating shaft 303. Movement of the sliding groove swing arm 3023 can drive the fastening bracket 306 to slide. In other words, the fastening bracket 306 can also slide during rotation. This improves opening/closing effect of the hinge structure 30.

It may be understood that the at least two damping plates 3021 may be disposed on the synchronization swing arm 3022, and the at least two damping plates 3021 may be disposed at an end, facing the compression spring 305, of the synchronization swing arm 3022.

Still refer to FIG. 4 and FIG. 6. The hinge structure 30 may include two bases 301, and the two bases 301 may be disposed at two ends of the synchronization swing arm 3022 respectively, to improve stability in rotation of the synchronization swing arm 3022 around the rotating shaft 303, thereby improving rotational effect of the hinge structure 30.

Still refer to FIG. 3. The hinge structure 30 further includes a door plate member 308, the swing arm assembly 302 may be assembled on the door plate member 308, and the swing arm assembly 302 may be connected to a foldable part of the electronic device through the door plate member 308.

To improve stability of an operation of opening/closing the electronic device, a plurality of groups of swing arm assemblies 302 may be disposed between the door plate member 308 and the foldable part of the electronic device.

For example, as shown in FIG. 3, three groups of swing arm assemblies 302 may be disposed between the door plate member 308 and the foldable part of the electronic device.

It should be noted that a quantity of swing arm assemblies 302 between the door plate member 308 and the foldable part of the electronic device includes but is not limited to the foregoing quantity.

Still refer to FIG. 6 and FIG. 7. The sliding groove swing arm 3023 includes a sliding groove body 30231 and a first swing arm 30232 disposed on the sliding groove body 30231, and a first installation groove 302321 is provided on the first swing arm 30232.

The synchronization bracket 307 includes a bracket body 3071 and a first connection part 3072 disposed on the bracket body 3071, the first connection part 3072 is located in the first installation groove 302321, and the first swing arm 30232 and the first connection part 3072 are sleeved on the rotating shaft 303 together.

The first connection part 3072 may be a connection part matching the first installation groove 302321.

In this implementation, the first connection part 3072 matches the first installation groove 302321, and the first connection part 3072 and the first swing arm 30232 are strung on the rotating shaft 303, so that linkage between the sliding groove swing arm 3023 and the synchronization bracket 307 can be implemented. In this way, under cooperative connection between the synchronization swing arm 3022 and the synchronization bracket 307, rotation of the synchronization swing arm 3022 can drive the synchronization bracket 307 and the sliding groove swing arm 3023 to move along the rotating shaft 303, to implement an operation of unfolding or closing the hinge structure 30.

Still refer to FIG. 6 and FIG. 8. A sliding groove 302311 is provided on the sliding groove body 30231, a guide pillar 3061 is disposed on the fastening bracket 306, the guide pillar 3061 is assembled in the sliding groove 302311, and the guide pillar 3061 is capable of moving relative to the sliding groove 302311.

In a case that the fastening bracket 306 rotates relative to the base 301, the sliding groove 302311 cooperates with the guide pillar 3061 to drive the synchronization bracket 307 and the sliding groove swing arm 3023 to move along the rotating shaft 303.

In this implementation, when the fastening bracket 306 rotates relative to the base 301, rotation of the synchronization swing arm 3022 can drive the synchronization bracket 307 and the sliding groove swing arm 3023 to move along the rotating shaft 303. Movement of the sliding groove swing arm 3023 can drive, through cooperation between the sliding groove 302311 and the guide pillar 3061, the guide pillar 3061 to slide, that is, drive the fastening bracket 306 to slide. In other words, the fastening bracket 306 can also slide during rotation. This improves opening/closing effect of the hinge structure 30.

Optionally, an accommodation groove 30221 matching the sliding groove body 30231 may be further provided on the synchronization swing arm 3022, so that the sliding groove body 30231 can be accommodated in the accommodation groove 30221, to lower a requirement for a thickness of the swing arm assembly 302, and further reduce the overall volume of the hinge structure 30.

Optionally, the bracket body 3071 may be located between the first swing arm 30232 and the at least two damping plates 3021, and because the at least two damping plates 3021 may be disposed at the end, facing the compression spring 305, of the synchronization swing arm 3022, the synchronization bracket 307 and the sliding groove swing arm 3023 may move away from a first end of the rotating shaft 303. The first end of the rotating shaft 303 is an end of the rotating shaft 303 at which the compression spring 305 is disposed.

Optionally, the hinge structure 30 includes at least two friction plates 304, and the at least two damping plates 3021 and the at least two friction plates 304 are sequentially alternately disposed and stacked. Increasing a quantity of friction plates 304 can further increase the rotational friction force between the friction plate 304 and the damping plates 3021 and improve damping effect in rotation of the hinge structure 30.

In some implementations, in a case that the hinge structure 30 includes a plurality of friction plates 304, the compression spring 305 may abut against a friction plate disposed on an outer side of the at least two damping plates 3021, so that the elastic restoring force of the compression spring 305 can directly act on the friction plate, to reduce a transmission loss of the elastic restoring force, thereby increasing the rotational friction force between the friction plate and the damping plates and improving damping effect of the hinge structure 30.

Optionally, a rotating shaft cap may be disposed on the end of the rotating shaft 303 at which the compression spring 305 is disposed, so that an end of the compression spring 305 abuts against the rotating shaft cap and the other end abuts against the swing arm assembly 302. In this way, the compression spring 305 may be in a compressed state, and can apply elastic force to the swing arm assembly 302.

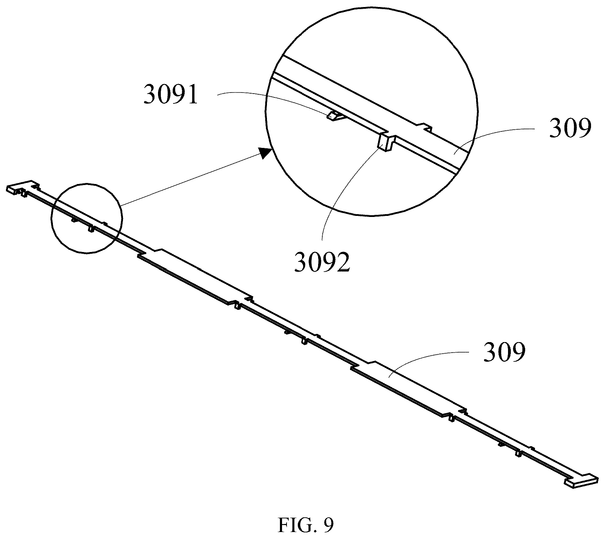

Refer to FIG. 9. FIG. 9 is a diagram of a structure of a floating plate shown in FIG. 3. As shown in FIG. 3, FIG. 6, FIG. 7, and FIG. 9, the hinge structure 30 further includes a floating plate 309, the floating plate 309 is disposed on the base 301, and the floating plate 309 is disposed opposite to the synchronization bracket 307.

A first sliding groove 30711 is provided on the bracket body 3071, and a guide column 3091 matching the first sliding groove 30711 is disposed on the floating plate 309.

When the synchronization bracket 307 moves along the rotating shaft 303, the first sliding groove 30711 cooperates with the guide column 3091 to drive the floating plate 309 to move up and down relative to the synchronization bracket 307.

The hinge structure 30 further includes a hinge cover 310, and the hinge cover 310 may be disposed corresponding to the floating plate 309.

In this implementation, the first sliding groove 30711 cooperates with the guide column 3091, so that the floating plate 309 can move up and down. In other words, lifting and lowering movement of the floating plate 309 can be implemented. This can lower a requirement for a thickness design of the hinge structure 30 and reduce a protrusion amount of the hinge cover 310, to satisfy a requirement for a thin and light design of the hinge structure 30.

Still refer to FIG. 4 and FIG. 9. A guide groove 3011 is provided on the base 301, and a guide rail 3092 matching the guide groove 3011 is disposed on the floating plate 309. The guide rail 3092 is slidably connected to the guide groove 3011, to prevent positional deviation when the floating plate 309 moves up and down relative to the base 301, and improve structural stability of the hinge structure 30.

In this way, the elastic restoring force of the compression spring 305 acts on the surface contact between the at least two damping plates 3021 and the friction plate 304, so that the rotational friction force between the at least two damping plates 3021 and the friction plate 304 can be increased, to improve damping effect in rotation of the hinge structure 30. In addition, because the damping plates 3021, the friction plate 304, and the compression spring 305 are all sleeved on the rotating shaft 303, the overall volume of the hinge structure 30 can be effectively reduced in comparison with achieving damping effect of a hinge structure by disposing a concave-convex wheel spring assembly.

In some implementations, the hinge structure 30 may include two swing arm assemblies, two rotating shafts, and two compression springs. The two swing arm assemblies may include a first swing arm assembly and a second swing arm assembly, the two rotating shafts may include a first rotating shaft and a second rotating shaft, and the two compression springs may include a first compression spring and a second compression spring.

The first swing arm assembly may be rotatably connected to the base 301 through the first rotating shaft, and the second swing arm assembly may be rotatably connected to the base 301 through the second rotating shaft.

The first swing arm assembly includes at least two first damping plates, the at least two first damping plates are sleeved on the first rotating shaft, the at least two first damping plates are rotatably connected to the first rotating shaft, a first end part of the friction plate 304 may be disposed between the at least two first damping plates, the at least two first damping plates are in surface-contact connection to the first end part of the friction plate 304, the first compression spring may be sleeved on the first rotating shaft, and the first compression spring abuts against the first swing arm assembly. Elastic restoring force of the first compression spring can increase rotational friction force between the at least two first damping plates and the first end part of the friction plate 304, to improve damping effect in rotation of the first swing arm assembly relative to the base 301.

Correspondingly, the second swing arm assembly includes at least two second damping plates, the at least two second damping plates are sleeved on the second rotating shaft, the at least two second damping plates are rotatably connected to the second rotating shaft, a second end part of the friction plate 304 may be disposed between the at least two second damping plates, the at least two second damping plates are in surface-contact connection to the second end part of the friction plate 304, the second compression spring may be sleeved on the second rotating shaft, and the second compression spring abuts against the second swing arm assembly. Elastic restoring force of the second compression spring can increase rotational friction force between the at least two second damping plates and the second end part of the friction plate 304, to improve damping effect in rotation of the second swing arm assembly relative to the base 301.

It should be noted that both the first swing arm assembly and the second swing arm assembly include a synchronization swing arm and a sliding groove swing arm, and the first swing arm assembly and the second swing arm assembly share one synchronization bracket 307. A structure design of the hinge structure 30 can be optimized and the overall volume of the hinge structure 30 can be reduced in comparison with designing two synchronization brackets 307 to implement rotation of the first swing arm assembly and the second swing arm assembly.

According to the foregoing structure design, the at least two first damping plates of the first swing arm assembly and the at least two second damping plates of the second swing arm assembly may share one set of friction plates 304. In comparison with using two sets of friction plates to implement damping rotating shafts of the first swing arm assembly and the second swing arm assembly respectively, the structure design of the hinge structure 30 can be effectively simplified, a design layout of the hinge structure 30 can be further optimized, and the overall volume of the hinge structure 30 can be reduced.

In the descriptions of the specification, the description with reference to a term such as "an embodiment", "some embodiments", "an illustrative embodiment", "an example", "a specific example", or "some examples" means that a specific feature, structure, material, or characteristic described with reference to the embodiment or example is included in at least one embodiment or example of this application. In the specification, the foregoing example expressions of the terms are not necessarily with respect to a same embodiment or example. In addition, the described specific features, structures, materials, or characteristics may be combined in a proper manner in any one or more embodiments or examples.

Although embodiments of this application have been illustrated and described, a person of ordinary skill in the art can understand that various changes, modifications, replacements, and variants may be made to these embodiments without departing from the principle and purpose of this application, and the scope of this application is limited by the claims and their equivalents.

## Claims

1. A hinge structure, comprising a base, a swing arm assembly, a rotating shaft, a friction plate, and a compression spring, wherein the rotating shaft is disposed on the base, both the swing arm assembly and the friction plate are disposed on the rotating shaft, and the swing arm assembly is rotatably connected to the rotating shaft; and
the swing arm assembly comprises at least two damping plates, the at least two damping plates are sleeved on the rotating shaft, the at least two damping plates are rotatably connected to the rotating shaft, the friction plate is disposed between the at least two damping plates, the at least two damping plates are in contact with the friction plate, the compression spring is sleeved on the rotating shaft, and the compression spring abuts against the swing arm assembly.

2. The hinge structure according to claim 1, wherein the hinge structure further comprises a fastening bracket and a synchronization bracket, the synchronization bracket is disposed on the rotating shaft, the swing arm assembly comprises a synchronization swing arm and a sliding groove swing arm, the at least two damping plates are disposed on the synchronization swing arm, and the fastening bracket is connected to the sliding groove swing arm;
the synchronization swing arm is connected to the synchronization bracket; and
in a case that the fastening bracket rotates relative to the base, the fastening bracket drives the synchronization swing arm to rotate, and the synchronization swing arm cooperates with the synchronization bracket to drive the synchronization bracket and the sliding groove swing arm to move along the rotating shaft.

3. The hinge structure according to claim 2, wherein the sliding groove swing arm comprises a sliding groove body and a first swing arm disposed on the sliding groove body, and a first installation groove is provided on the first swing arm; and
the synchronization bracket comprises a bracket body and a first connection part disposed on the bracket body, the first connection part is located in the first installation groove, and the first swing arm and the first connection part are sleeved on the rotating shaft together.

4. The hinge structure according to claim 3, wherein the hinge structure further comprises a floating plate, the floating plate is disposed on the base, and the floating plate is disposed opposite to the synchronization bracket;
a first sliding groove is provided on the bracket body, and a guide column matching the first sliding groove is disposed on the floating plate; and
when the synchronization bracket moves along the rotating shaft, the first sliding groove is cooperatively connected to the guide column to drive the floating plate to move up and down relative to the synchronization bracket.

5. The hinge structure according to any one of claims 1 to 4, wherein the hinge structure comprises at least two friction plates, and the at least two damping plates and the at least two friction plates are sequentially alternately disposed and stacked.

6. The hinge structure according to claim 2, wherein the at least two damping plates are disposed on the synchronization swing arm, and the at least two damping plates are located at an end, close to the compression spring, of the synchronization swing arm.

7. The hinge structure according to claim 3, wherein an accommodation groove matching the sliding groove body is provided on the synchronization swing arm, and the sliding groove body is accommodated in the accommodation groove.

8. The hinge structure according to claim 3, wherein the bracket body is located between the first swing arm and the at least two damping plates.

9. The hinge structure according to claim 3, wherein a sliding groove is provided on the sliding groove body, a guide pillar is disposed on the fastening bracket, the guide pillar is assembled in the sliding groove, and the guide pillar is capable of moving relative to the sliding groove; and
in a case that the fastening bracket rotates relative to the base, the sliding groove cooperates with the guide pillar to drive the synchronization bracket and the sliding groove swing arm to move along the rotating shaft.

10. An electronic device, comprising a first foldable part, a second foldable part, and the hinge structure according to any one of claims 1 to 9, wherein the first foldable part is rotatably connected to the second foldable part through the hinge structure.
